# EUROPEAN PATENT APPLICATION

(11) **EP 4 553 810 A1**
(43) Date of publication of application: **14.05.2025**
(21) Application number: 23835036.7
(22) Date of filing: 06.07.2023
(51) Int. Cl.: G09B 9/00

(54) **METHOD AND SYSTEM FOR SIMULATING WELDING OPERATIONS**

(30) Priority: 06.07.2022 ES 202230616
(71) Applicant: Seabery Soluciones, S.L., 21005 Huelva (ES)
(72) Inventor: GUNIA, Pavel, 21459 El Rompido, Huelva (ES); CASTILLA GUTIÉRREZ, Javier, 21006 Huelva (ES); MARQUÍNEZ, Pedro, Severna Park, Maryland 21146 (US)
(74) Representative: TRBL Intellectual Property
(86) International application number: PCT/IB2023/056999
(87) International publication number: WO 2024/009259

(57) **Abstract**

The invention relates to a method for simulating welding operations, designed to determine, in a simulation environment, the shape and volume of a weld bead (4) based on input welding parameters for each of the one or more passes (3, 3', 3") of welding material, wherein said shape and volume are calculated as a succession of interconnected cross sections (10). The method according to the invention comprises, advantageously, calculating the weld throat plane (11) associated with the cross sections (10) of the weld bead (4) for each pass (3, 3', 3"), and based on said weld throat plane (11), calculating one or more mechanical properties of the weld bead (4) for said cross sections (10). The invention also relates to a simulation system comprising means configured for implementing the method described.

## Description

### FIELD OF THE INVENTION

The present invention generally relates to field of learning by means of augmented reality techniques, and more specifically, to methods and to systems for simulating welding operations using a computer, preferably by means of augmented reality methods. In the scope of the present invention, the term "augmented reality" will be understood to furthermore refer to any other visual representation techniques by means of virtual reality or by means of mixed reality.

### BACKGROUND OF THE INVENTION

Known systems and methods for simulating attachment operations by material deposition, such as welding operations, require intensive use of graphics processing resources for performing the simulations. In that sense, in conventional welding simulation systems, the calculations and representation of the simulated weld bead (i.e., the weld material wire deposited at the interface of the welded surfaces) require considerable computational power. This effectively limits the equipment on which such simulation can be implemented, generally being limited to computers with dedicated graphics processing units. By way of example, mobile devices and/or web browsers generally do not allow for the implementation of conventional welding simulation techniques. Furthermore, said conventional systems and methods are cumbersome to implement and present difficulties for the development of new characteristics and functionalities, such as the implementation of complex weld shapes and/or the simulation of different welding materials.

In known welding simulation techniques, the amount of material transferred from the welding tool used (e.g. a welding torch, a welding electrode, a robotic welding arm, etc.) to the weld bead cannot be modelled with high precision, as a consequence of the aforementioned computational limitations. However, obtaining a precise modelling of the weld bead is crucial in this field to realistically simulate the successive passes of deposited material performed in each welding operation.

With the aim of improving conventional welding simulation techniques, several solutions have been developed in recent years that allow the computational requirements of the simulation operations to be substantially reduced, while maintaining realistic and even photorealistic display results, obtaining simulation images that are comparable to the results of a real weld. An example of these techniques is described in patent application WO 2019/171172 A1. Said document describes a method for simulating a weld bead by means of segmenting said bead into a plurality of cross sections, which facilitates its calculation and subsequent rendering in a simulation environment, as it requires fewer computational resources than other alternatives known in the prior art.

As a consequence of the recent improvement in welding operation simulation techniques, it would be desirable to develop methods for the realistic calculation of the mechanical properties of the weld bead, which can be used as indicators of the quality of the weld achieved in each operation, through the tool used (welding torch, robotic arm, etc.). Having these indicators is of great value in the field of training and learning technologies for welding skills since, with this, the people who are learning, as well as their teachers, can obtain quantitative information about the quality of a given operation. In the field of robotic welding, this capability would allow for the refinement of the learning methods of welding robots.

It is important to clarify that, to date, there are no mature techniques for calculating the mechanical properties of simulated weld seams, which are furthermore feasible in terms of the demand for computational resources. Therefore, the only realistic alternative to this possibility, at present, is to perform real welding tests, which requires the consumption of significant material resources, mainly in the form of workpieces and welding material, with the consequent environmental impact, and entails a higher risk of accidents for less experienced users, which furthermore necessarily imposes a greater need for human supervision.

In this context, obtaining the aforementioned methods for simulating mechanical properties would also be very valuable for being able to simulate a wide variety of welding tests, both of the destructive type (traction, torsion, or compression of the welded piece to verify its mechanical properties and strength, as well as the possible existence of welding defects) and non-destructive type (for example, optical or acoustic tests). Again, obtaining realistic information on these properties by means of simulation would represent significant savings in materials and human costs, with a corresponding benefit in terms of safety and environmental impact.

Moreover, having techniques for simulating calculation of the mechanical welding properties can also be beneficial in real welding operations. In this context, the realistic simulation of the mechanical properties of a simulated weld bead, based on the characteristics of a real weld bead, can advantageously replace traditional techniques based on destructive and non-destructive tests, having a very high cost and need for specialisation.

The present invention is aimed at solving the above problems and limitations, by means of a novel method for simulating welding operations, and a system that implements this method.

### BRIEF DESCRIPTION OF THE INVENTION

The object of the method and the system of the invention is preferably the simulation of welding attachment operations as represented and described, respectively, in relation to the description, figures, and claims herein.

More specifically, a first object of the invention generally relates to a method and to a system adapted to provide a simulation environment by means of augmented reality, comprising hardware/software means adapted to support the calculation, rendering, and display of preferably three-dimensional (3D) graphics, as well as communication means between users of simulation software, together with an implementation of mathematical methods and/or algorithms simulating 3D welding processes.

The method and the system of the invention are implemented, in a preferred embodiment thereof, by means of software that can be used, for example, to administer a virtual classroom intended for learning welding techniques, and for applying augmented reality simulating a welding process in a real environment. Therefore, by means of using augmented reality techniques, the virtual images corresponding to the welding operations, generated using a computer, are superimposed or transposed onto real environments for defining and/or creating an augmented, virtual, or mixed reality providing users with a tool for learning different welding techniques. In some examples of the invention, the user (for example, a welder or a welding apprentice) uses a screen, video glasses, and/or any other display device adapted for that purpose. The screen or the glasses can, in turn, be integrated into a commercial welding mask and present the mixed reality to a user using the welding mask. A realistic simulation of real welding conditions is thereby achieved.

While the present invention usually refers to operations performed by a user, said user is to be understood generically not only as a human user, but also as any robotic element performing or testing the welding operations.

The embodiments of the systems and methods described as an example of the invention preferably provide a simulated visual representation of welding workpieces (generally referred to as "coupons"). However, said workpieces will be understood, in the scope of the invention, to mean any real or simulated elements which comprise the regions which are welded. In that sense, for example, in addition to the coupons, a workpiece can be understood to mean an industrial part, a vehicle, a constructive element, or a real or simulated engineering element on which the welding operation is to be performed.

In turn, the weld beads obtained with the simulation method and system of the invention realistically represent the typically longitudinal depositions of welding material, in one or more passes, depending on the type of welding operation performed. In different embodiments of the invention, said method and system can be used to realistically reproduce the generation of defects in the weld bead, such that a user can see them and better understand how and why they have occurred, learning to avoid them in successive operations. In other embodiments, the systems and methods of the invention can distinguish between different techniques used to form a weld and represent it, realistically, under different formats in the display means chosen to represent the simulation.

In relation to the conventional simulation of welding operations, the systems and methods described by the invention allow correctly calculating the amount of material transferred from a welding tool to a workpiece, adjusting the concavity or convexity of the geometry of the bead to improve the precision of the interaction between different passes, improving the representation of the welds formed. It is thereby possible to control the unnatural growth of the lack of movement of the welding tool, providing a precise transition between the workpiece and the weld bead, and simulating with precision the melting of the workpieces and the underlying welding materials, among many other advantages. Compared to known methods and systems, the invention furthermore allows the realistic calculation of the mechanical properties of the weld beads obtained, showing them to the user in a detailed manner along the bead for each successive pass of deposited material. This improved capability cannot be obtained in real welding operations because in such operations, the weld bead is formed in a non-reversible manner as the successive passes of material are deposited on top of one another.

Additionally, the embodiments of the systems and methods of the invention are essentially based on the calculation of the cross sections of the weld bead for the purpose of calculating the mechanical properties of said bead along the extension thereof. The invention thereby allows the representation of the mentioned mechanical properties of the weld bead at any location of the section, which allows indicating to the user, among other advantages, the points of the bead at which the weld has been made with less or more resistance, wherein passes have been made which improve or do not improve said properties, etc. This capability cannot be obtained with conventional techniques.

To calculate the mechanical properties of the weld bead, the present invention is based on incorporating the calculation of the value of the generated weld throat plane for the cross sections of the bead. In welding theory, this magnitude is defined as the maximum area contained in a cross section of the weld bead, said area being delimited by a straight line perpendicular to the bisector traced between the two elements to be welded (typically, two workpieces or two portions of a workpiece to be welded). The value of the weld throat plane can be related directly to the mechanical strength of the bead in a given section, knowing the welding material. Although this ratio between the weld throat plane and the welding material is generally known in the prior art, its application to simulated welding techniques is novel with respect to the methods known in the present invention. Furthermore, as previously mentioned, the application of the calculation of the weld throat plane to weld beads simulated allows knowing the mechanical strength with each successive pass of material, which is not possible in a real weld, as mentioned.

More specifically, a first object of the invention relates to a method for simulating a welding operation, wherein said welding operation represents the application of one or more passes of welding material on a physical workpiece, and wherein said passes of welding material configure a weld bead, wherein said method comprises the operation of:
- a physical tool operable by a user, said user being a human being or a robotic component; and
- a simulation equipment connected to the physical tool;

wherein said simulation equipment is adapted with hardware and software means comprising a welding parameter detector, a weld calculator, a rendering device, and a display;
wherein said method comprises performing the following steps with the simulation equipment:
   - rendering, with the rendering device, at least one simulation domain in which the weld bead is represented within a three-dimensional welding space; and at least one of a simulated workpiece and a simulated welding tool representing, respectively, the physical workpiece and the physical tool within the three-dimensional welding space; and
   - detecting, with the weld detector, one or more input welding parameters that characterise a welding operation performed by a user with the physical tool, for one or more passes of welding material, wherein said input welding parameters comprise at least one of the following: volume of the deposited material, surface of the deposited material, composition of the deposited material, type of welding process, welding voltage, welding current, wire feed rate, type of electrode, composition of the electrode, type of welding gas, welding gas flow rate.

Advantageously, the method according to the invention further comprises the following steps:
- determining, with the calculator, the shape and volume of the weld bead based on the input welding parameters for each of the passes, wherein said shape and volume are calculated as a succession of interconnected cross sections which, together, configure the weld bead;
- rendering, with the rendering device, the weld bead in the simulation domain;
- calculating, with the calculator, the weld throat plane associated with the cross sections of the weld bead, for each pass, and from said weld throat plane, calculating one or more mechanical properties of the weld bead for said cross sections;
- representing with the display, the rendered weld bead together with information relative to the weld throat plane and/or to the calculated mechanical properties of said weld bead for the cross sections in the simulation domain, and for one or more passes of welding material.

In a preferred embodiment of the method of the invention, the information relative to the mechanical properties of the weld bead comprises a representation, on the display, of information in the form of a colour scale along the weld bead. More preferably, the information relative to the mechanical properties of the weld bead comprises the value of the mechanical strength of the weld bead, obtained based on the weld throat plane in the cross sections.

In another preferred embodiment of the invention, the information relative to the mechanical properties of the weld bead comprises one or more values relative to the mechanical strength of the weld bead, obtained based on the weld throat plane of the cross sections. More preferably, the values relative to the mechanical strength of the weld bead comprise the compressive stress, tensile stress, and/or torsional stress.

In another preferred embodiment of the invention, the information relative to the weld throat plane comprises a representation of the passes along the weld bead.

In another preferred embodiment of the invention, the input parameters detected by the weld detector comprise the volume of the deposited material, the surface of the deposited material, the composition of the deposited material, the type of welding process, welding voltage, welding current, wire feed rate, type of electrode, composition of the electrode, type of welding gas, and/or the welding gas flow rate corresponding to a real welding operation.

In another preferred embodiment of the invention, the physical workpiece and/or the physical tool comprise at least one position indicator, wherein the method further comprises a step in which at least one position detector is arranged, adapted to receive information corresponding to the position of the workpiece and/or of the physical tool, by means of the position indicator;
and wherein the method further comprises performing the following steps:
- obtaining, with the position detector, information corresponding to the location of the physical workpiece and/or of the physical tool by means of the indicator;
- determining, with the position detector, the position and the orientation of the physical workpiece and/or of the physical tool, obtaining information about at least one of the following elements: a part of the physical workpiece and/or of the physical tool which are visible in a field of view; the distance between the position detector and the physical workpiece and/or the physical tool, the location and orientation of the physical tool in relation to the physical workpiece; the orientation of the physical workpiece based on the information of the detector; and
- representing, with the display, the simulation domain based on the mapping of the position indicator to positions in a simulated workpiece and/or a simulated welding tool.

In another preferred embodiment of the method of the invention, the steps of determining, with the detector, the position and the orientation of the physical workpiece and/or of the physical tool comprises obtaining information about at least one of the following: working angle, angle of travel, rate of travel, working distance between the physical workpiece and/or of the physical tool.

In another preferred embodiment of the invention, the information relative to the mechanical properties of the weld bead comprises information with respect to at least one value relative to the maximum mechanical strength of the weld bead.

In another preferred embodiment of the invention, the value relative to the maximum mechanical strength of the weld bead comprises information according to at least one of the following: number of passes, geometric discontinuities, inclusions, position of the geometric discontinuities, position of the inclusions, type of attachment, position, welding material, and/or welding process.

In another preferred embodiment of the invention, the information relative to the mechanical properties of the weld bead comprises information with respect to a position of the weld bead wherein the value of the mechanical strength of the weld bead is maximum.

In a preferred embodiment of the method of the invention, the information relative to the mechanical properties of the weld bead comprises a representation, on the display, in the form of a colour scale along the piece.

In another preferred embodiment of the invention, prior to the welding operation, information relative to one or more mechanical forces applied to the simulated workpiece is input in the simulation equipment, wherein said mechanical forces are represented on the display and parameterised by a modulus, a sense, and/or a direction.

In another preferred embodiment of the invention, the parameterisation of the modulus, the sense, and/or the direction of the mechanical forces are set prior to performing the welding operation and/or modified during the welding operation depending on the input welding parameters.

In another preferred embodiment of the invention, depending on the parameterisation of the mechanical forces, at least one of the following execution parameters for a weld is represented on the display: weld geometry, welding process, and/or number of passes, wherein said execution parameters are shown prior to and/or during the welding operation.

In another preferred embodiment of the invention, the steps of calculating, with the calculator, the weld throat plane associated with the cross sections of the weld bead for each pass further comprises the estimation of the carbon footprint generated in each of the passes, and/or in the simulated welding operation. More preferably, in another embodiment of the invention, the estimation of the carbon footprint generated in a simulated welding operation further comprises saving, in the simulation equipment, information relative to said estimation of the carbon footprint for each of the simulated welding operations performed with the simulation equipment. More preferably, in another embodiment of the invention, the information saved in the simulation equipment relative to the estimation of the carbon footprint for each of the simulated welding operations performed with the simulation equipment comprises a value relative to the learning progression of the simulated welding operations performed. More preferably, in another preferred embodiment of the invention, the estimation of the carbon footprint generated in a simulated welding operation further comprises calculating the ratio between said carbon footprint and the value relative to the learning progression of the simulated welding operations performed.

In another preferred embodiment of the invention, the steps of calculating, with the calculator, the weld throat plane associated with the cross sections of the weld bead for each pass further comprises calculating the ratio between the value of the weld throat plane and the carbon footprint of each of the passes, wherein said ratio is characterised by being correct, excessive, or inferior.

In another preferred embodiment of the invention, the steps of calculating, with the calculator, the weld throat plane associated with the cross sections of the weld bead for each pass further comprises calculating the ratio between the carbon footprint of each of the passes of a weld made on a simulated workpiece subjected to one or more mechanical forces and its welding procedure specification (WPS).

In another preferred embodiment of the method of the invention, the step of representing, with the display, the rendered weld bead together with information relative to the weld throat plane and/or to the calculated mechanical properties of said weld bead comprises representing the rendered weld bead in a plurality of regions of a simulated workpiece, wherein said regions are occlusive from at least one viewpoint in the simulation domain. And more preferably, the occlusive regions are on opposite surfaces of the simulated workpiece.

Even more preferably, in the method of the invention:
- the physical workpiece comprises a plurality of position indicators for said physical workpiece;
- the position indicators comprise one or more of the following: optical markers, printed markers, and/or natural markers; and
- the position indicators are arranged in regions of the physical workpiece corresponding to the occlusive regions of the simulated workpiece.

A second object of the invention relates to a system for simulating a welding operation, wherein said welding operation represents the application of one or more passes of welding material on a physical workpiece, and wherein said passes of welding material configure a weld bead; wherein said system comprises:
- a physical tool operable by a user, said user being a human being or a robotic component; and
- a simulation equipment connected to the physical tool (said connection being understood to mean any means that allow the exchange of information between the simulation equipment and the physical tool, or of one with respect to the other), wherein said simulation equipment is adapted with hardware and software means comprising a welding parameter detector, a weld calculator, a rendering device, and a display;
and wherein, advantageously, the simulation equipment is adapted to carry out the steps of a method according to any of the embodiments described herein.

In a preferred embodiment of the system of the invention, the physical tool comprises a real welding tool, a training tool, and/or a real weld inspection tool.

In another preferred embodiment of the system of the invention, the physical tool comprises a robotic arm or a robotic tool.

In another preferred embodiment of the invention, the system comprises at least one position indicator for a physical workpiece and/or of the physical tool, and additionally comprises at least one position detector, adapted to receive information corresponding to the position of the workpiece and/or of the physical tool by means of the position indicator.

In another preferred embodiment of the system of the invention, the position indicator comprises one or more of the following: optical markers, printed markers, and/or natural markers.

In another preferred embodiment of the system of the invention, wherein the position detector comprises one or more of the following: cameras, inertial sensors, haptic sensors, thermal sensors, mechanical sensors, electromagnetic sensors.

### DESCRIPTION OF THE DRAWINGS

The features, aspects, and advantages of the present invention will be understood in greater detail on the basis of the detailed description provided below in reference to the attached drawings in which similar characters represent similar parts in all the figures, in which:

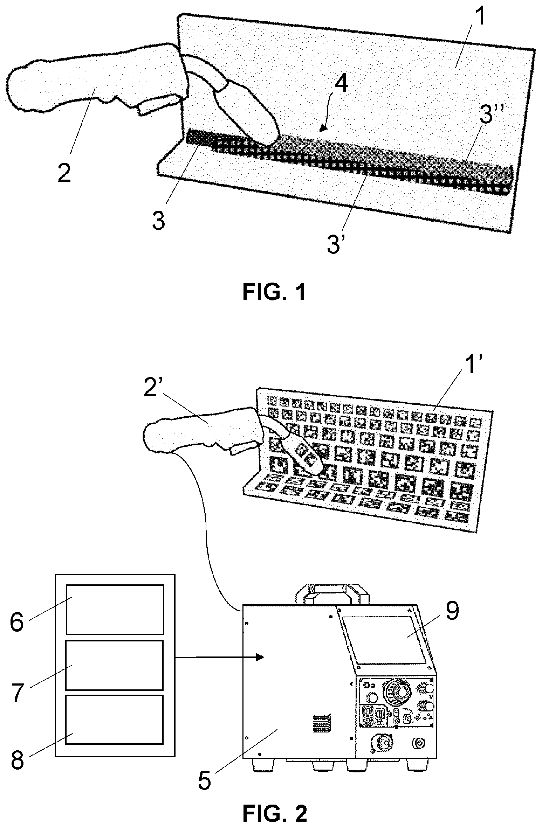

Figure 1 shows a perspective view of the main elements simulated with the method of the invention, in a preferred embodiment thereof, showing a simulated weld bead formed by three simulated passes of material (distinguished in the figure by three filler patterns), wherein said simulated bead is deposited on a simulated workpiece by means of a simulated welding tool which, for said embodiment, represents a welding torch.
Figure 2 schematically represents the main elements of the simulation equipment of the invention in a preferred embodiment thereof.

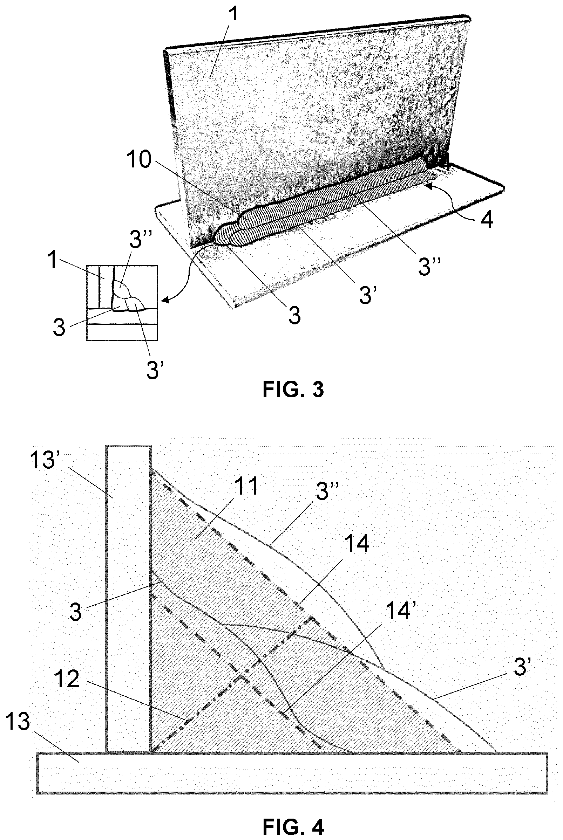

Figure 3 shows a perspective view of the weld bead obtained based on the method of the invention, wherein the shape and volume of said weld bead are calculated as a succession of interconnected cross sections which, together, correspond to one or more simulated passes of welding material. Likewise, an enlarged profile view of the simulated passes of welding material deposited on a simulated workpiece for one of said sections is represented on the left side of figure.
Figure 4 illustrates, by way of example, obtaining the value of the weld throat plane by means of the tracing of two straight lines, based on the bisector corresponding to a weld bead comprising three passes of material, arranged between two welded elements in a T-shaped attachment. In this example, one line of the two traced lines is the one that defines a larger area in the cross section and, accordingly, the one that determines the weld throat plane of the weld bead for each cross section thereof.

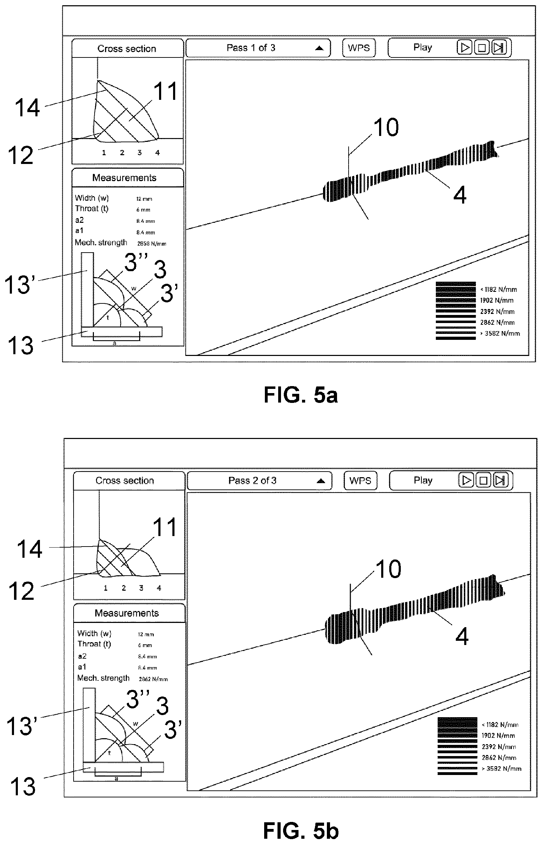

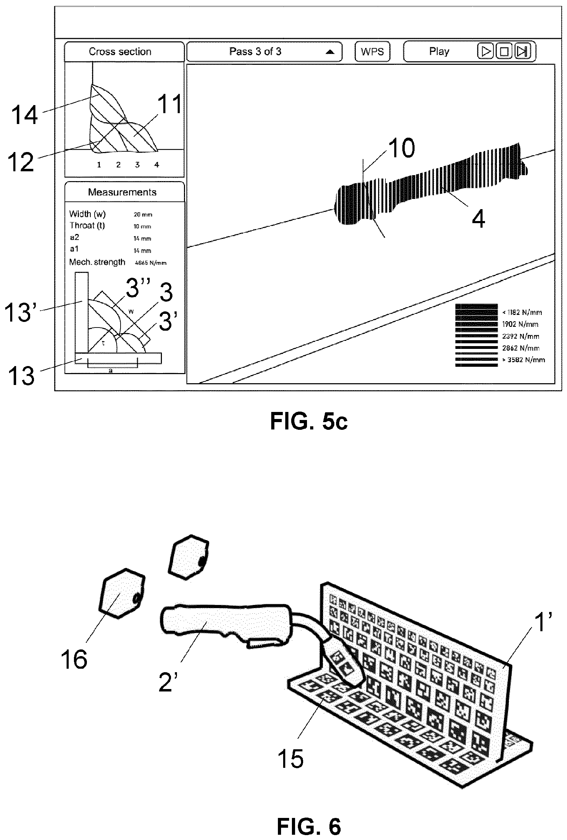

Figures 5a-5c show an exemplary representation, by means of the method of the invention, of the information relative to the mechanical properties of the weld bead in the form of a colour scale along said bead for an embodiment of the invention based on three simulated passes of welding material. Therefore, the mentioned information is represented in each of said figures for each pass in an incremental manner.
Figure 6 illustrates a preferred embodiment of the invention, wherein the workpiece and/or the tool comprise one or more position indicators, as well as one or more position detectors adapted to receive information corresponding to the position of the workpiece and/or of the tool.

### Reference numbers used in the description

- (1): Simulated workpiece
- (1'): Physical workpiece
- (2): Simulated welding tool
- (2'): Physical tool
- (3, 3', 3"): Simulated passes of welding material
- (4): Simulated weld bead
- (5): Simulation equipment
- (6): Welding parameter detector
- (7): Weld calculator
- (8): Rendering device
- (9): Display
- (10): Cross sections of the weld bead
- (11): Weld throat plane of the cross section
- (12): Bisector defining the weld throat plane
- (13, 13'): Welded elements in a workpiece or workpieces
- (14', 14'): Lines traced based on the bisector to define the weld throat plane
- (15): Position indicators for the physical workpiece or of the physical tool
- (16): Position detectors of the indicators

### DETAILED DESCRIPTION OF THE INVENTION

Figures 1-6 herein describe a series of preferred embodiments of the invention which are incorporated for illustrative and, therefore, non-limiting purposes of the scope of protection of the claims.

As described in the previous sections, a first object of the invention relates to a method for simulating a welding operation, wherein said simulation is preferably performed in an augmented reality, virtual reality, or mixed reality environment. In this environment, as shown in Figure 1, the simulated welding operation preferably represents the application of a simulated welding material on a simulated workpiece (1), wherein the mentioned application of material is performed by means of a simulated welding tool (2) (where said tool (2) can be, for example, a simulated welding torch, a simulated welding electrode, a simulated robotic welding arm, a simulated welding inspection tool, etc.). With this representation, the simulated welding material is deposited as one or more simulated passes (3, 3', 3") (understood to mean substantially longitudinal extensions of simulated welding material that can be arranged on other extensions, being completely or partially superimposed on one another as they are generated), and wherein the assembly formed by said simulated passes (3, 3', 3") configures a simulated weld bead (4). Therefore, the simulated passes (3, 3', 3") represent the passes of material which typically form real weld beads.

Depending on whether the application of the invention refers to virtual, augmented, or mixed reality, given elements simulated through the described method (for example, the simulated workpiece (1), the simulated welding tool (2), etc.) can be generated in relation to corresponding real elements, such as a physical workpiece (1') or a physical tool (2'), where the latter can be, in different embodiments, a real welding tool (i.e., adapted for the deposition of real welding material) or a training tool (having dimensions, weight, or other properties that are similar to those of a real welding tool, but without the capability of depositing real welding material). In other embodiments of the invention, the physical tool (2') may comprise a real weld inspection tool, configured for obtaining, for example, information about the surface, volume, shape, or composition of the material corresponding to a real weld bead based on which the simulation of the weld bead (4) can be generated. The physical tool (2') can be operated by a human, robotic, or computerised user, both directly and indirectly, based on a corresponding interface or control means.

Therefore, by way of non-limiting example, in an augmented reality environment, the method of the invention may comprise the representation of a simulated workpiece (1) and of a simulated welding tool (2) on a physical workpiece (1') and a physical tool (2'), respectively (said physical elements are represented in Figure 2 herein). As previously mentioned, in different embodiments of the invention, a physical workpiece (1') can be understood to mean an industrial part, a vehicle, a constructive element, an engineering element, or a part thereof, on which the welding operation and/or the corresponding simulation thereof is to be performed.

In a preferred embodiment of the invention, as illustrated in Figure 2, the method according to the invention comprises the operation of simulation equipment (5), wherein said simulation equipment (5) is adapted with hardware and software means comprising a welding parameter detector (6), a weld calculator (7), a rendering device (8), and a display (9). While in a preferred embodiment of the invention said simulation equipment (5) can be used connected to a physical tool (2'), in other embodiments it can be used independently of said tool (2'). However, in general the simulation equipment (5) will be adapted to receive information obtained from the operation of the mentioned physical tool (2'), for example based on its interaction with a human, robotic, or computerised user, and/or with a physical workpiece (1'), which generates data relative to the simulated welding operation that can be analysed by the detector (6). In different embodiments of the invention, the connection between the simulation equipment (5) and the physical tool (2') can be produced by means of a material connection (for example, through a cable and/or information port) or wirelessly, and both directly and through intermediate elements, adapted for the exchange of said data between the simulation equipment (5) and the physical tool (2'), or to provide information of one with respect to the other.

Typically, the simulation equipment (5) may comprise any type of computer or a mobile device (for example, a mobile telephone, a tablet, etc.). In turn, as mentioned, the welding parameter detector (6) is adapted to receive and process information relative to one or more of the following parameters relative to the material or type of weld: volume of the deposited material, surface of the deposited material, composition of the deposited material, type of welding process, welding voltage, welding current, wire feed rate, type of electrode, composition of the electrode, type of welding gas, welding gas flow rate. The simulations of the welding operations are thereby mainly based on the input information that the simulation equipment (5) receives about the properties of the material or type of weld, according to the mentioned parameters. Likewise, in different embodiments of the invention, the input information can be generated in an artificial manner (for example, by means of simulation parameterisations, neural networks, artificial intelligence tools) or in a real manner, through the analysis of information corresponding to the deposition of a real welding material, for example and in a non-limiting manner, by means of the analysis of the properties of the shape, volume, or composition of a real weld bead (4) successively deposited on a physical workpiece (1') in one or more passes.

In other preferred embodiments of the invention, other parameters detected by the detector (6) may comprise information relative to the position or the movement of the physical tool (1') (such as, for example, the working angle, the angle of travel, the rate of travel, or the working distance existing between the physical tool (1') and the physical workpiece (2')), and/or of the corresponding simulated elements thereof.

The weld calculator (7) is configured, in turn, for calculating the shape and volume of the weld bead (4) based on the input welding parameters processed by the detector (6). Preferably, said calculation is performed for each pass (3, 3', 3") of simulated welding material. In general, the calculation techniques associated with the determination of the shape and volume of the weld bead (4) based on welding parameters are known and described in detail, by way of non-limiting example of the invention, in patent application WO 2019/171172 A1.

The rendering device (8) is configured for generating information of realistic or photorealistic images based on two-dimensional (2D) or three-dimensional (3D) models in a simulation environment. 2D or 3D model-based rendering techniques are generally known in the prior art.

The display (9) is configured for representing and displaying the information of images generated by the rendering device (8). To that end, in different embodiments of the invention, the display (9) may comprise a monitor or a screen, which is optionally a touch screen.

For the different preferred embodiments described above, the method according to the invention comprises carrying out, with the simulation equipment (5), the following steps, in any technically possible order:
i) Rendering, with the rendering device (8), at least one simulation domain in which the simulated weld bead (4) is represented in a three-dimensional welding space, and at least one of a simulated workpiece (1) and a simulated welding tool (2) representing, respectively, the physical workpiece (1') and the physical tool (2') within the mentioned three-dimensional welding space.
ii) Detecting, with the weld detector (6), one or more input welding parameters that characterise the operation performed by a user with the physical tool (2'), wherein said parameters comprise at least one of the following: volume of the deposited material, surface of the deposited material, composition of the deposited material, type of welding process, welding voltage, welding current, wire feed rate, type of electrode, composition of the electrode, type of welding gas, welding gas flow rate
iii) Determining, with the calculator (7), the shape and volume of the weld bead (4) based on the input welding parameters, wherein said shape and volume are calculated as a succession of interconnected cross sections (10) which, together, correspond to one or more simulated passes (3, 3', 3") of welding material (see Figure 3). Therefore, each of the mentioned sections (10) substantially corresponds to different cross sections of the weld bead (4) formed by completely or partially superimposing the passes (3, 3', 3") comprised in said bead (4).
iv) Rendering, with the rendering device (8), the weld bead (4) in the simulation domain.

Advantageously, the method according to the invention further comprises the following steps:
v) Calculating, with the calculator (7), the weld throat plane (11) associated with the welding parameters detected for each of the cross sections (10) of the simulation domain, and based on said weld throat plane (11), calculating one or more mechanical properties of the weld bead (4) for each of said cross sections (10).

As previously described, in welding theory, the weld throat plane (11) corresponds to the maximum area contained in a cross section (10) of the weld bead (4), said area being defined by a straight line perpendicular to the bisector (12) traced between the two pieces or elements (13, 13') to be welded, as illustrated in Figure 4. Said figure represents the tracing of two straight lines (14, 14') (defined as discontinuous lines) based on the bisector (12) (defined as a discontinuous line with points) corresponding to a weld bead (4) comprising three passes (3, 3', 3") of material, arranged between two elements (13, 13') welded in a T shape. In this example, one line (14) of the two traced lines is the one that defines a larger area in the cross section (10) and, accordingly, the one that determines the weld throat plane (11) (represented as the region occupying the striped section of Figure 4). The determination of said weld throat plane (11), together with the information about the composition of the welding material, allows univocally determining (typically by means of prior parameterisation) the mechanical strength of the weld bead (4) in each section (10) and, accordingly, determining one or more mechanical properties of said bead (4) based on the calculated value of the mechanical strength.
vi) Representing, with the display (9), the rendered weld bead (4) together with information relative to the weld throat plane (11) and/or to the mechanical properties of said weld bead (4), for each of the cross sections (10) of the simulation domain in one or more welding passes (3, 3', 3").

Advantageously in the invention, throughout a simulated welding operation it is possible to calculate the mechanical properties of the weld bead (4) in an incremental manner with each pass (3, 3', 3"). It is thereby possible to verify how said properties change with successive passes (3, 3', 3"), which is not possible in a real welding operation. This capability is extremely important and valuable for the welding skills training processes, since the increase in passes (3, 3', 3") does not necessarily improve the mechanical strength of the weld bead (4). In this sense, the invention substantially improves the capability of analysing mechanical properties of the bead (4) with respect to other known techniques, including real weld analysis techniques. Therefore, in different preferred embodiments of the invention, it is possible to show the information relative to the weld throat plane (11) for each successive pass (3, 3', 3") along the weld bead (4).

In a preferred embodiment of the invention, the information relative to the mechanical properties of the weld bead (4) may comprise a representation in the form of a colour scale along the bead (4), for each pass (3, 3', 3") of simulated welding material. An example of this type of representation is shown in Figures 5a-5c herein. In said figures, it can be seen how, based on the effective values of the width (w), weld throat (t) (obtained based on the bisector (12)) and lengths (a1, a2) welded in each element (13, 13') of the workpiece or workpieces, it is possible to calculate the weld throat plane (11) for each pass (3) in the sections (10) of the weld bead (4). And, based on the value of the weld throat plane (11), it is possible to calculate, for example, the value of the mechanical strength along the bead (4). Figures 5a-5c represent an exemplary weld based on three passes (3, 3', 3") of simulated welding material, wherein the information about the value of the mechanical strength (shown as a colour scale) is represented for each successive pass (3, 3', 3"), respectively. In a preferred embodiment of the invention, this information can be shown on the display (9) of the welding equipment or through any other means of representing information wherein, for example, the simulated weld bead (4), the passes (3, 3', 3") applied, and the weld throat plane (11) associated with same can be represented together for each cross section (10) of the weld bead (4). In different embodiments of the invention, said information can be represented statically in a given section (10), or dynamically by means of a play functionality which shows the values obtained by moving along the weld bead (4), for example, as the simulated welding material is deposited during the application of each pass (3, 3', 3"), or when the welding operation for each pass (3, 3', 3") has been completed. In different embodiments, said play functionality can be configured to move forward or backward along the weld bead (4) both in time and in space, either during the welding operation, as the weld bead (4) is being formed with each pass (3, 3', 3"), or else when said welding operation has been completed.

Additionally, based on the value of the mechanical strength in each cross section (10), it is possible to calculate other mechanical properties obtained based on same, such as the compressive stress, tensile stress, and/or torsional stress of the simulated weld bead (4). Once again, it is important to note that the results obtained based on the method of the invention provide detailed information for each section (10) defined, which allows realistically knowing the mechanical properties of the weld bead (4) at the millimetric or micrometric scale along each of its successive passes (3).

In another preferred embodiment of the invention, the information relative to the mechanical properties of the weld bead (4) comprises information with respect to at least one value relative to the maximum mechanical strength of the weld bead (4). With this functional, the maximum of the calculated mechanical strengths of the weld bead (4) is determined.

In another preferred embodiment of the invention, it is possible to determine the value relative to the maximum mechanical strength of the weld bead (4) considering the phenomena that typically take place during real welding processes that modify the mechanical strength of the weld bead (4). Such phenomena include the number of passes (3), the presence of geometric discontinuities and inclusions of slag or tungsten, the position of the geometric discontinuities, the position of the inclusions, the type of attachment of the weld, the position, the welding material, and/or the welding process.

In another preferred embodiment of the invention, the information relative to the mechanical properties of the weld bead (4) comprises information with respect to a position of the weld bead (4) wherein the value of the mechanical strength of the weld bead (4) is maximum. This functionality allows associating the value relative to the maximum strength of the weld bead (4) with the position of the weld bead (4) where the strength of the weld bead (4) corresponds with the value of said maximum strength.

Additionally, in another preferred embodiment of the invention, the information relative to the mechanical properties of the weld bead (4) comprises a representation, on the display (9), in the form of a colour scale along the piece.

In another preferred embodiment of the invention, prior to the welding operation, information relative to one or more mechanical forces applied to the simulated workpiece (1) is input in the simulation equipment (5), wherein said mechanical forces are represented on the display (9) and parameterised by a modulus, a sense, and a direction. In the present invention, the terms modulus, sense, and direction refer to modulus, sense, and direction of the force vector. This embodiment allows evaluating the quality of the weld in terms of the mechanical strength of the weld bead (4) against mechanical stresses generated by the information relative to the mechanical force or forces applied to the simulated workpiece (1).

In another preferred embodiment of the invention, the parameterisation of the modulus, sense, and/or direction of the mechanical forces are set prior to performing the welding operation and/or modified during the welding operation depending on the input welding parameters. In an example of this particular embodiment, prior to the welding operation, the user establishes the parameterisation referring to the modulus, sense, and/or direction of the mechanical forces, such that said parameterisation is applied to the simulated workpiece (1) during the welding operation, simulating that mechanical forces of modulus, sense, and/or direction are applied to the piece according to the initially established parameterisation. In another example of this particular embodiment, once the welding operation has started, the user can modify the initially established parameterisation relating to the modulus, sense, and/or direction of the mechanical forces. By modifying these parameters, it is possible to modulate the mechanical stresses generated on the piece and, therefore, modulate the mechanical strength of the piece (1) against newly parameterised mechanical forces. In another example of this particular embodiment, during the welding operation, in addition to modifying the initially set parameterisation, the user can set additional parameterisations relating to new mechanical forces. New mechanical stresses will thereby be generated on the simulated workpiece (1).

In another preferred embodiment of the invention, depending on the parameterisation of the mechanical forces, at least one of the following execution parameters for a weld is represented on the display (9): weld geometry, welding process, and/or number of passes, wherein said execution parameters are shown prior to and/or during the welding operation. With said functionality, the execution parameters represented prior to the welding operation are determined based on the initial parameterisation of the modulus, sense, and/or direction of the forces, such that by following said parameters, the user after the welding operation obtains a weld bead (4) with good mechanical strength against mechanical stresses generated by the parameterised mechanical forces. Additionally, the execution parameters can be proposed during the welding operation, acting as corrective measures. Therefore, if the user does not make a suitable weld during the welding operation, the simulation equipment (5) proposes execution parameters that allow the welder to rectify the weld until achieving one that is suitable. By following said parameters, the welding operation is modified until achieving a weld with a good strength against the mechanical stresses generated by the parameterised mechanical forces. This embodiment is applicable to any weld calculation method and is not limiting for the calculation of the weld bead (4).

In another preferred embodiment of the invention, the steps of calculating, with the calculator (7), the weld throat plane (11) associated with the cross sections of the weld bead (4) for each pass (3) further comprises the estimation of the carbon footprint generated in each of the passes (3). In the present invention, the carbon footprint is understood to mean the environmental impact represented by carrying out the welding operation, where this is based on one or more of the input welding parameters, such as: volume of the deposited material, surface of the deposited material, composition of the deposited material, type of welding process, welding voltage, welding current, wire feed rate, type of electrode, composition of the electrode, type of welding gas, welding gas flow rate.

In another preferred embodiment of the invention, the estimation of the carbon footprint generated in a simulated welding operation further comprises saving, in the simulation equipment (5), information relative to said estimation of the carbon footprint for each of the simulated welding operations performed with the simulation equipment (5). With this functionality, it is possible to save in the simulation equipment (5) the information relating to the carbon footprint generated for each of the welding operations performed by the user.

In another preferred embodiment of the invention, the information saved in the simulation equipment (5) relative to the estimation of the carbon footprint for each of the simulated welding operations performed with the simulation equipment (5) comprises a value relative to the learning progression of the simulated welding operations performed. In this invention, value relative to the learning progression is understood to mean the mean value of all the carbon footprints generated during each welding operation carried out by the user.

In another preferred embodiment of the invention, the estimation of the carbon footprint generated in a simulated welding operation further comprises calculating the ratio between said carbon footprint and the value relative to the learning progression of the simulated welding operations performed. The calculated ratio is represented on the display (9). In one embodiment, given this functionality, the simulation equipment (9) would show the mean value of said ratio needed to obtain a valid rating. In another embodiment, the simulation equipment (9) would estimate the slope of the learning evolution to be followed to obtain a valid rating and given this slope, it would estimate where the user is on said slope. The user is considered to have acquired a valid rating when said user is ready to perform standard welds after achieving a good result in the simulated welding operations.

In another preferred embodiment of the invention, the steps of calculating, with the calculator (7), the weld throat plane (11) associated with the cross sections of the weld bead (4) for each pass (3) further comprises calculating the ratio between the value of the weld throat plane (11) and the carbon footprint of each of the passes (3). It is possible to evaluate the ratio between the weld throat plane (11) and the carbon footprint generated in the resulting attachment after several passes (3) or to evaluate said ratio for each of the passes (3) independently. The ratio is thereby evaluated as being correct, too high, or too low, and the result thereof is represented on the display (9) after the welding operation. A correct ratio is understood to mean one in which the value of the weld throat plane (11) is the correct value and the value of the carbon footprint is the lowest value possible for the attachment or pass (3) of welding material to take place. In contrast, a ratio that is too high is understood to mean one in which the welding material input is more than that required or the geometry of the piece is incorrect according to the parameters defined by either international standards or by WPS or IWM. In the case of obtaining a ratio that is too low, it is necessary to distinguish between the passes (3) of welding material and the total weld. For each pass (3), a lower carbon footprint value is obtained, which must be compensated by a higher material input in the next pass (3). On the other hand, for each complete weld, by generating a throat plane (11) lower than what is required, it is necessary to evaluate whether it is possible to carry out another pass of welding material.

In another preferred embodiment of the invention, the steps of calculating, with the calculator (7), the weld throat plane (11) associated with the cross sections of the weld bead (4) for each pass (3) further comprises calculating the ratio between the carbon footprint of each of the passes (3) of a weld made on a simulated workpiece (1) subjected to one or more mechanical forces and its welding procedure specification (WPS). The minimum geometry needed to carry out the weld and the minimum impact of said geometries on the environment are thereby determined. The result of the calculated ratio is represented on the display (9) once the welding operation is complete.

In another preferred embodiment of the invention, the simulation method comprises the operation of a physical workpiece (1') and/or of a physical tool (2'), wherein said workpiece (1') and/or said tool (2') comprise one or more position indicators (15) (see Figure 6), where said indicators (15) may comprise, for example, optical markers such as LEDs, QR codes, barcodes, retroreflective spheres, and/or printed markers; as well as natural markers such as characteristic points of the workpiece (1') and/or of the tool (2') (for example, the corners of said elements can be used as characteristic points, without the need for having external marking or identification elements on same). In these embodiments, it is possible to incorporate one or more position detectors (16) adapted to receive information corresponding to the position of the workpiece (1') and/or of the tool (2'). Said position detectors (16) may comprise, by way of non-limiting example, one or more cameras and/or, in other embodiments, other detection means such as inertial sensors, haptic sensors, thermal sensors, mechanical sensors, electromagnetic sensors, etc.

In the preceding embodiment, based on indicators (15) and position detectors (16), the method according to the invention further comprises performing the following steps:
- obtaining, with the detectors (16), information corresponding to the location of the physical workpiece (1') and/or of the physical tool (2') by means of the identification of the position indicators (15);
- determining, with the detectors (16), the position and the orientation of the physical workpiece (1') and/or of the physical tool (2'), obtaining information about at least one of the following elements: a part of the physical workpiece (1') and/or of the physical tool (2') which are visible in a field of view; the distance between the detectors (16) and the physical workpiece (1') and/or the physical tool (2'), the location and orientation of the physical tool (2') in relation to the physical workpiece (1'); the orientation of the physical workpiece (1') based on the information of the detectors (16); and
- representing , with the display (9), the simulation domain based on the mapping of the position indicators (15) to positions in a simulated workpiece (1) and/or a simulated welding tool (2).

According to the preceding method, the steps of determining, with the detectors (16), the position and the orientation of the physical workpiece (1) and/or of the physical tool (2) preferably comprises obtaining information about at least one of the following: working angle, angle of travel, rate of travel, working distance between the physical workpiece (1) and/or the physical tool (2).

In another embodiment possible of the method of the invention, the step of representing, with the display (9), the rendered weld bead (4) together with information relative to the weld throat plane (11) and/or to the calculated mechanical properties of said weld bead (4), comprises representing the rendered weld bead (4) in a plurality of regions of a simulated workpiece (1), wherein said regions are occlusive from at least one viewpoint in the simulation domain. In the scope of interpretation of the invention, the occlusive regions are those which, from the selected viewpoint, would prevent being seen simultaneously on the real workpiece (1'). This would happen, for example, in a piece (1') in the form of a plate in which it was necessary to weld on both sides of said piece, and wherein the real welding operation would generally not allow seeing both regions simultaneously, since one would block the other from the operator's or welder's viewpoint. In that sense, for example, said embodiment of the method of the invention is particularly advantageous when the occlusive regions are on opposite surfaces of the simulated workpiece (1) (this situation is common in welding operations performed during the manufacture, repair, or maintenance of ships). Advantageously in the invention, the display (9) allows displaying the information relative to the formation of the bead (4) in all or part of the occlusive regions and, therefore, the user can more precisely understand how they did in the joint operation relative to said regions. Furthermore, the mentioned information will also preferably include the calculation, with the calculator (8), of the weld throat plane (11) associated with the cross sections (10) of the weld bead (4) in the occlusive regions for each pass (3, 3', 3"), and based on said weld throat plane (11), calculating one or more mechanical properties of the weld bead (4) for said cross sections (10).

With the described embodiment, the physical workpiece (1') more preferably comprises a plurality of position indicators (15) for said physical workpiece (1'), wherein the position indicators (15) comprise one or more of the following: optical markers, printed markers, and/or natural markers. And additionally, the position indicators are arranged in regions of the physical workpiece (1') corresponding to the occlusive regions of the simulated workpiece (1).

A second aspect of the invention relates to a system for simulating a welding operation, wherein said welding operation represents the application of one or more passes (3, 3', 3") of welding material on a physical workpiece (1'), and wherein said passes (3, 3', 3") of welding material configure a weld bead (4);
wherein said system comprises:
   - a physical tool (2') operable by a user; and
   - simulation equipment (5) connected to the physical tool (2), wherein said simulation equipment (5) is adapted with hardware and software means comprising a welding parameter detector (6), a weld calculator (7), a rendering device (8), and a display (9);
and wherein the hardware/software means of the simulation equipment (5) are advantageously adapted to carry out the steps of a method according to any of the embodiments described herein.

## Claims

1. A method for simulating a welding operation, wherein said welding operation represents the application of one or more passes (3, 3', 3") of welding material on a physical workpiece (1'), and wherein said passes (3, 3', 3") of welding material configure a weld bead (4);
wherein said method comprises the operation of:
- a physical tool (2') operable by a user; and
- a simulation equipment (5) connected to the physical tool (2'),
wherein said simulation equipment (5) is adapted with hardware and software means comprising a welding parameter detector (6), a weld calculator (7), a rendering device (8), and a display (9);
wherein said method comprises performing the following steps with the simulation equipment (5):
- rendering, with the rendering device (8), at least one simulation domain in which the weld bead (4) is represented within a three-dimensional welding space; and at least one of a simulated workpiece (1) and a simulated welding tool (2) representing, respectively, a physical workpiece (1') and a physical tool (2') within the three-dimensional welding space;
- detecting, with the weld detector (6), one or more input welding parameters that characterise a welding operation for one or more passes (3, 3', 3") of welding material, wherein said input welding parameters comprise at least one of the following: volume of the deposited material, surface of the deposited material, composition of the deposited material, type of welding process, welding voltage, welding current, wire feed rate, type of electrode, composition of the electrode, type of welding gas, welding gas flow rate;
and wherein the method is **characterized in that** it further comprises the following steps:
- determining, with the calculator (7), the shape and volume of the weld bead (4) based on the input welding parameters for each of the passes (3, 3', 3"), wherein said shape and volume are calculated as a succession of interconnected cross sections (10) which, together, configure the weld bead (4);
- rendering, with the rendering device (8), the weld bead (4) in the simulation domain;
- calculating, with the calculator (8), the weld throat plane (11) associated with the cross sections (10) of the weld bead (4) for each pass (3, 3', 3"), and from said weld throat plane (11), calculating one or more mechanical properties of the weld bead (4) for said cross sections (10);
- representing, with the display (9), the rendered weld bead (4) together with information relative to the weld throat plane (11) and/or to the calculated mechanical properties of said weld bead (4) for the cross sections (10) in the simulation domain, and for one or more passes (3, 3', 3") of welding material.

2. The method according to the preceding claim, wherein the information relative to the mechanical properties of the weld bead (4) comprises a representation, on the display (9), of information in the form of a colour scale along the weld bead (4).

3. The method according to any of the preceding claims, wherein the information relative to the mechanical properties of the weld bead (4) comprises the value of the mechanical strength of the weld bead (4), obtained based on the weld throat plane (11) in the cross sections (10).

4. The method according to any of the preceding claims, wherein the information relative to the mechanical properties of the weld bead (4) comprises one or more values relative to the mechanical strength of the weld bead (4), based on the weld throat plane (11) of the cross sections (10).

5. The method according to the preceding claim, wherein the values relative to the mechanical strength of the weld bead (4) comprise the compressive stress, tensile stress, and/or torsional stress.

6. The method according to any of the preceding claims, wherein the information relative to the weld throat plane (11) comprises a representation of the passes (3, 3', 3") along the weld bead (4) and/or its corresponding mechanical properties.

7. The method according to any of the preceding claims, wherein the input parameters detected by the weld detector (6) comprise information corresponding to a real welding operation.

8. The method according to any of the preceding claims, wherein the user is a human, robotic, or computerised user, and wherein the physical tool (2') is operated directly or indirectly based on an interface or control means.

9. The method according to any of the preceding claims, wherein the physical workpiece (1') and/or the physical tool (2') comprise at least one position indicator (15), and wherein at least one position detector (16) is further arranged, adapted to receive information corresponding to the position of the workpiece (1') and/or of the physical tool (2') by means of the position indicator (15);
and wherein the method further comprises performing the following steps:
- obtaining, with the position detector (16), information corresponding to the location of the physical workpiece (1') and/or of the physical tool (2') by means of the indicator (15);
- determining, with the position detector (16), the position and the orientation of the physical workpiece (1') and/or of the physical tool (2'), obtaining information about at least one of the following elements: a part of the physical workpiece (1') and/or of the physical tool (2') which are visible in a field of view; the distance between the position detector (16) and the physical workpiece (1') and/or the physical tool (2'), the location and orientation of the physical tool (2') in relation to the physical workpiece (1'); the orientation of the physical workpiece (1') based on the information of the detector (16); and
- representing, with the display (9), the simulation domain based on the mapping of the position indicator (15) to positions in a simulated workpiece (1) and/or a simulated welding tool (2).

10. The method according to the preceding claim, wherein the step of determining, with the detector (16), the position and the orientation of the physical workpiece (1') and/or of the physical tool (2') comprises obtaining information about at least one of the following: working angle, angle of travel, rate of travel, working distance between the physical workpiece (1) and/or the physical tool (2).

11. The method according to any of the preceding claims, wherein the information relative to the mechanical properties of the weld bead (4) comprises information with respect to at least one value relative to the maximum mechanical strength of the weld bead (4).

12. The method according to the preceding claim, wherein the value relative to the maximum mechanical strength of the weld bead (4) comprises information according to at least one of the following: number of passes, geometric discontinuities, inclusions, position of the geometric discontinuities, position of the inclusions, type of attachment, position, welding material, and/or welding process.

13. The method according to any of claims 11-12, wherein the information relative to the mechanical properties of the weld bead (4) comprises information with respect to a position of the weld bead (4) wherein the value of the mechanical strength of the weld bead (4) is maximum.

14. The method according to any of claims 11-13, wherein the information relative to the mechanical properties of the weld bead (4) comprises a representation, on the display (9), in the form of a colour scale along the piece.

15. The method according to any of the preceding claims, wherein prior to the welding operation, information relative to one or more mechanical forces applied to the simulated workpiece (1) is input in the simulation equipment (5), wherein said mechanical forces are represented on the display (9) and parameterised by a modulus, a sense, and/or a direction.

16. The method according to the preceding claim, wherein the parameterisation of the modulus, the sense, and/or the direction of the mechanical forces are set prior to performing the welding operation and/or modified during the welding operation depending on the input welding parameters.

17. The method according to the preceding claim, wherein depending on the parameterisation of the mechanical forces, at least one of the following execution parameters for a weld is represented on the display (9): weld geometry, welding process, and/or number of passes, wherein said execution parameters are shown prior to and/or during the welding operation.

18. The method according to any of the preceding claims, wherein the steps of calculating, with the calculator (7), the weld throat plane (11) associated with the cross sections of the weld bead (10) for each pass (3) further comprises the estimation of the carbon footprint generated in each of the passes (3) and/or in the simulated welding operation.

19. The method according to the preceding claim, wherein the estimation of the carbon footprint generated in a simulated welding operation further comprises saving, in the simulation equipment (5), information relative to said estimation of the carbon footprint for each of the simulated welding operations performed with the simulation equipment (5).

20. The method according to the preceding claim, wherein the information saved in the simulation equipment (5) relative to the estimation of the carbon footprint for each of the simulated welding operations performed with the simulation equipment (5) comprises a value relative to the learning progression of the simulated welding operations performed.

21. The method according to the preceding claim, wherein the estimation of the carbon footprint generated in a simulated welding operation further comprises calculating the ratio between said carbon footprint and the value relative to the learning progression of the simulated welding operations performed.

22. The method according to any of claims 18-21, wherein the steps of calculating, with the calculator (7), the weld throat plane (11) associated with the cross sections of the weld bead (10) for each pass (3) further comprises calculating the ratio between the value of the weld throat plane and the carbon footprint of each of the passes, wherein said ratio is **characterised by** being correct, excessive, or inferior.

23. The method according to any of claims 18-22, wherein the steps of calculating, with the calculator (7), the weld throat plane (11) associated with the cross sections of the weld bead (10) for each pass (3) further comprises calculating the ratio between the carbon footprint of each of the passes of a weld made on a simulated workpiece subjected to one or more mechanical forces and its welding procedure specification.

24. The method according to any of the preceding claims, wherein the step of representing, with the display (9), the rendered weld bead (4) together with information relative to the weld throat plane (11) and/or to the calculated mechanical properties of said weld bead (4) comprises representing the rendered weld bead (4) in a plurality of regions of a simulated workpiece (1), wherein said regions are occlusive from at least one viewpoint in the simulation domain.

25. The method according to the preceding claim, wherein the occlusive regions are on opposite surfaces of the simulated workpiece (1).

26. The method according to any of claims 24-25, wherein:
- the physical workpiece (1') comprises a plurality of position indicators (15) for said physical workpiece (1');
- the position indicators (15) comprise one or more of the following: optical markers, printed markers, and/or natural markers; and
- the position indicators are arranged in regions of the physical workpiece (1') corresponding to the occlusive regions of the simulated workpiece (1).

27. A system for simulating a welding operation, wherein said welding operation represents the application of one or more passes (3, 3', 3") of welding material on a physical workpiece (1'), and wherein said passes (3, 3', 3") of welding material configure a weld bead (4);
wherein said system comprises:
- a physical tool (2') operable by a user; and
- a simulation equipment (5) connected to the physical tool (2'), wherein said simulation equipment (5) is adapted with hardware and/or software means comprising a welding parameter detector (6), a weld calculator (7), a rendering device (8), and a display (9);
**characterized in that** the hardware and/or software means of the simulation equipment (5) are adapted to carry out the steps of a method according to any of the preceding claims.

28. The system according to the preceding claim, wherein the physical tool (2') comprises:
- a real welding tool, and/or
- a training tool.

29. The system according to any of claims 27-28, wherein the physical tool (2') comprises a robotic arm.

30. The system according to any of claims 27-29, comprising:
- at least one position indicator (15) for a physical workpiece (1') and/or of the physical tool (2'), and additionally
- at least one position detector (16), adapted to receive information corresponding to the position of the workpiece (1') and/or of the physical tool (2') by means of the position indicator (15).

31. The system according to claims 27-30, wherein the position indicator (15) comprises one or more of the following: optical markers, printed markers, and/or natural markers.

32. The system according to claims 27-31, wherein the position detector (16) comprises one or more of the following: cameras, inertial sensors, haptic sensors, thermal sensors, mechanical sensors, electromagnetic sensors.
